# FASCICULE DE BREVET EUROPEEN

(11) **EP 2 571 286 B1**
(45) Date de publication et mention de la délivrance du brevet: **04.03.2015**
(21) Numéro de dépôt: 12182044.3
(22) Date de dépôt: 28.08.2012
(51) Int. Cl.: H04R 3/04, H04R 3/08, H03G 3/00, H04R 3/00

(54) **Procédé de renforcement des fréquences graves dans un signal audio numérique**
Verfahren zur Verstärkung der tiefen Frequenzen in einem digitalen Audiosignal
Method for reinforcing the bass frequencies in a digital audio signal

(30) Priorité: 13.09.2011 FR 1158164
(43) Date de publication de la demande: 20.03.2013
(73) Titulaire: Parrot, 75010 Paris (FR)
(72) Inventeur: Pochon, Benoît, 75010 Paris (FR); Hoang Co Thuy, Vu, 77330 Ozoir La Ferriere (FR)
(74) Mandataire: Dupuis-Latour, Dominique

(56) Documents cités:
- US-A- 4 327 250
- US-A1- 2005 207 584
- US-A1- 2008 175 397
- US-B1- 6 201 873

## Description

L'invention concerne une technique de renforcement des fréquences basses dans une installation de reproduction sonore.

Il s'agit d'améliorer la restitution audio des fréquences les plus graves dans une installation comprenant une enceinte acoustique pourvue d'un haut-parleur électrodynamique pour les graves, souvent désigné *woofer.* Un tel haut-parleur produit une onde sonore en réponse à un signal électrique appliqué en entrée, via une conversion électrique/mécanique (par une bobine dans laquelle on fait passer un courant électrique, plongée dans un champ magnétique créé par des pièces polaires et un aimant) puis mécanique/acoustique (par déplacement d'une membrane liée à la bobine et qui crée l'onde sonore).

Ces haut-parleurs sont généralement installés dans des enceintes ouvertes (système à évent) ou fermées, mais sont toujours plus ou moins limités dans la restitution des fréquences les plus graves, la limite basse (ou fréquence de coupure de l'enceinte) dépendant de la taille du haut-parleur, du volume de l'enceinte et du type de montage utilisé.

Pour augmenter artificiellement la restitution des basses fréquences et compenser l'atténuation des fréquences les plus graves au voisinage et en-deçà de la fréquence de coupure de l'enceinte, on a proposé divers procédés souvent désignés *"bass-boost"* pour augmenter artificiellement la restitution des basses fréquences, avec ce fait un meilleur rendu de la musique pour l'auditeur.

La technique la plus simple consiste à augmenter le niveau du signal électrique dans les fréquences basses par un filtrage approprié, analogique ou numérique. La bande passante est alors plus étendue dans les basses fréquences que sans traitement. Cette solution a toutefois ses limitations car l'excursion de la membrane du haut-parleur, c'est-à-dire l'amplitude de son déplacement par rapport à sa position d'équilibre, devient rapidement trop importante, avec un risque d'endommagement du haut-parleur et, à tout le moins, l'introduction pour des valeurs d'excursion excessives de distorsions qui viennent dégrader rapidement la qualité de restitution du signal audio. Une deuxième limitation concerne la puissance électrique en sortie : en effet, les amplificateurs délivrant la tension aux bornes du haut-parleur possèdent des limites propres. Si un filtre *bass-boost* est employé, le signal dans les basses fréquences (où l'énergie est la plus importante) atteindra plus rapidement les limites de l'amplificateur, risquant de faire saturer celui-ci ou de produire en sortie un son écrêté.

Le EP 2 113 913 A1 (Parrot) propose une technique basée sur une propriété psycho-acoustique de l'oreille humaine qui permet de percevoir des fréquences basses même si elles ne sont pas effectivement reproduites par le haut-parleur. En effet, la perception de la hauteur d'un son n'est pas seulement liée à la présence de la fréquence fondamentale dans le signal, mais également à celle d'harmoniques supérieures de cette fréquence. La technique proposée consiste à renforcer ces harmoniques, situées au-dessus de la fréquence de coupure de l'enceinte acoustique, de manière à produire l'illusion d'un renforcement de la fréquence fondamentale, pas ou peu reproduite. Cette technique est bien appropriée aux installations comportant des haut-parleurs de petit diamètre, comme les appareils portatifs ou les installations dans les véhicules automobiles. Mais dans la mesure où elle introduit dans le signal sonore des composantes qui ne s'y trouvaient pas à l'origine, elle ne convient pas aux installations "haute-fidélité" qui, par principe, cherchent à reproduire le signal sonore de la façon la plus conforme et avec le minimum d'altérations.

Le US 2008/0175397 A1 décrit un système permettant d'étendre vers le bas la bande passante de reproduction d'une enceinte acoustique, de façon dynamique en fonction de la puissance du signal à reproduire. La chaîne d'amplification comprend un filtre dynamique passe-haut dont la fréquence de coupure varie en fonction de la puissance du signal d'entrée (lorsque le signal est plus fort, la fréquence de coupure est relevée pour réduire les basses, et inversement). Le signal ainsi filtré est appliqué ensuite à un étage limiteur dont le gain varie de façon dynamique en fonction de quatre paramètres calculés en parallèle selon des modèles linéaires, indépendamment les uns des autres : excursion du haut-parleur, vitesse de l'air dans l'évent, détection de saturation audible de l'amplificateur, et température de la bobine du haut-parleur. Mais le fait d'utiliser un limiteur, qui agit sur la totalité du signal, a pour inconvénient d'introduire des non-linéarités et donc d'introduire de la distorsion harmonique. En outre, le calcul en parallèle, indépendamment les uns des autres, des différents facteurs conditionnant le gain du limiteur ne peut pas prendre en compte l'interaction entre ces paramètres, ni le comportement non-linéaire d'un haut-parleur.

Le EP 1 799 013 A1, quant à lui, propose une modélisation du comportement du haut-parleur, et une compensation des non-linéarités de celui-ci afin de disposer d'un système produisant moins de distorsions audio et procurant une meilleure qualité d'écoute en rendant le déplacement de la membrane du haut-parleur le plus linéaire possible. Mais il n'a pas pour objet d'étendre dynamiquement la bande passante du haut-parleur dans la région des fréquences les plus graves, ni de compenser les limitations physiques de la réponse de celui-ci dans cette région du spectre au voisinage et en-deçà de la fréquence de coupure acoustique de l'ensemble haut-parleur/enceinte.

Les US2005/0207584 A1, US 4 327 250 A et US 6 201 873 B1 décrivent d'autres techniques encore de filtrage, d'égalisation ou de traitement numérique du signal visant à prédire la réponse du haut-parleur et limiter si besoin le niveau du signal à reproduire, afin de se prémunir contre des excursions excessives du haut-parleur ou des non-linéarités génératrices de distorsions. Mais ces autres systèmes sont eux aussi sujets à tout ou partie des inconvénients précédemment évoqués.

L'invention a pour objet une technique *bass-boost* de renforcement des fréquences basses qui pallie les limitations des systèmes connus que l'on vient d'exposer.

Le but de l'invention est de proposer un procédé de filtrage dynamique, c'est-à-dire modifiable en temps réel, qui augmente le signal des fréquences les plus basses afin d'obtenir une réponse en fréquence du haut-parleur la plus plate possible (compensant l'atténuation de l'ensemble haut-parleur/enceinte au voisinage et en-deçà de la fréquence de coupure acoustique), lorsque cela est possible compte-tenu des contraintes mécaniques et électriques.

Plus précisément, l'invention vise à opérer un tel filtrage dont l'action diminue lorsque l'analyse du signal à reproduire indique que la musique jouée risque de provoquer un déplacement excessif de la membrane du haut-parleur, ou risque de produire une tension trop importante sur les étages de sortie de l'amplificateur, avec risque de saturation ou d'écrêtage du son reproduit.

Un tel filtrage dynamique est applicable notamment à une installation telle que celle décrite dans le WO 2008/139047 A2 (Parrot), qui décrit une enceinte acoustique active telle que celle commercialisée sous la dénomination *Zikmu* par Parrot, Paris, France. L'enceinte décrite dans ce document est une enceinte active à deux voies alimentées par un signal audio numérisé. La voie grave comprend un haut-parleur de basses ou *subwoofer* électrodynamique classique (c'est-à-dire de type pistonique) pour la reproduction des fréquences les plus graves, typiquement les fréquences inférieures à 200 Hz. Ce haut-parleur possède sa propre chaîne d'étages de puissance alimentée directement par les composantes de fréquences correspondantes (inférieures à 200 Hz) du signal numérique à reproduire.

Le principe de l'invention consiste à utiliser une chaîne de filtres de type *"lowshelf",* c'est-à-dire de filtres procurant une amplification prédéterminée (x dB/octave), fixe ou variable, pour les fréquences comprises dans une plage située autour d'une fréquence pivot ou "fréquence de coupure" donnée F₀, et une absence d'amplification pour les fréquences supérieures à une fréquence limite. Un tel filtre *lowshelf* procurera par exemple une amplification de +2 dB (ou +4 dB, +8 dB ...) à une fréquence pivot F₀ = 45 Hz, et aucune amplification (gain unité) pour les fréquences supérieures à 100 Hz.

Pour la mise en oeuvre de l'invention, ces filtres sont des filtrages numériques opérant sur un signal représentatif d'une tension, après conversion du signal audio numérique (sans dimension) en fonction du gain estimé de l'amplificateur de puissance qui sera utilisé en aval.

Essentiellement, dans un premier temps, le signal est appliqué à un premier filtre *lowshelf* puis une simulation du déplacement de la membrane du haut-parleur est comparée à une valeur limite admissible. En cas de dépassement, un premier facteur d'atténuation de consigne est calculé pour ne pas dépasser le seuil fixé.

Le signal initial est également appliqué à un deuxième filtre *lowshelf,* dont le gain est éventuellement modulé par le premier facteur d'atténuation calculé en fonction de l'excursion. Le signal résultant est appliqué à un comparateur permettant de vérifier que le signal de tension qui sera délivré par l'amplificateur ne dépasse pas une limite de saturation ou d'écrêtage donnée. En cas de dépassement, un second facteur d'atténuation de consigne est calculé.

Le signal initial est également appliqué à un troisième filtre *lowshelf,* dont le gain est éventuellement modulé par les premier et/ou second facteurs d'atténuation de consigne précédemment calculés. Le signal résultant est appliqué à un limiteur à action globale, comparant la tension délivrée à un seuil et atténuant le signal si ce seuil est dépassé.

Ces traitements en cascade (test de limitation sur l'excursion du haut-parleur, puis test sur la limitation en tension de l'amplificateur, avant une limitation globale) permettent de prendre en compte l'interaction entre les divers paramètres. De façon optionnelle mais avantageuse, ils permettent également d'introduire, comme on l'exposera plus loin, des traitements de compensation des non-linéarités, même si ces traitements risquent de produire un dépassement de l'excursion maximale du haut-parleur ou de la tension maximale de l'amplificateur.

Il est ainsi possible de simuler un comportement extrêmement réaliste de l'ensemble haut-parleur/amplificateur, et d'éviter toute action excessive de renforcement des fréquences basses qui pourrait engendrer des phénomènes de distorsion, d'écrêtage ou de saturation.

Plus précisément, l'invention propose un procédé de renforcement des fréquences graves du type général connu d'après le US 2008/0175397 A1 précité, c'est-à-dire un procédé applicable à un signal audio numérique destiné à être reproduit par un équipement comprenant un haut-parleur présentant des caractéristiques connues d'excursion en fonction du signal appliqué à ses bornes, et un amplificateur présentant des caractéristiques connues de tension maximale de saturation ou d'écrêtage.

De façon caractéristique, le procédé de l'invention comprend les étapes de traitements successives suivantes :
a) conversion du signal audio numérique, initialement sans dimension, en un autre signal numérique représentatif d'une tension électrique, en fonction d'un premier gain prédéterminé d'amplificateur analogique ;
b) application au signal obtenu à l'étape a) d'un premier filtrage de type *lowshelf,* apte à amplifier sélectivement, d'un deuxième gain prédéterminé, les fréquences inférieures à une fréquence pivot donnée ;
c) calcul d'une valeur courante d'excursion du haut-parleur pour le signal obtenu à l'étape b), en fonction des caractéristiques connues d'excursion ;
d) comparaison de la valeur courante d'excursion calculée à l'étape c) avec une valeur maximale d'excursion, et calcul d'un troisième gain d'atténuation éventuelle au cas où la valeur courante d'excursion dépasse la valeur maximale d'excursion ;
e) application au signal obtenu à l'étape a) d'un deuxième filtrage de type *lowshelf,* apte à amplifier sélectivement, d'un quatrième gain prédéterminé, non supérieur audit deuxième gain prédéterminé et le cas échéant réduit du troisième gain d'atténuation éventuelle calculé en amont à l'étape d), les fréquences inférieures à la fréquence pivot ;
g) comparaison du signal obtenu à l'étape e) avec la tension maximale de saturation ou d'écrêtage, et calcul d'un cinquième gain d'atténuation éventuelle au cas où l'amplitude de ce signal dépasse un seuil fonction de la tension maximale de saturation ou d'écrêtage ;
h) application au signal obtenu à l'étape a) d'un troisième filtrage de type *lowshelf,* apte à amplifier sélectivement, d'un sixième gain prédéterminé, non supérieur audit deuxième gain prédéterminé et le cas échéant réduit des troisième et cinquième gains d'atténuation éventuelle calculés en amont aux étapes d) et g), les fréquences inférieures à la fréquence pivot ;
k) conversion inverse du signal obtenu à l'étape h) en un signal audio numérique sans dimension, en fonction dudit premier gain prédéterminé d'amplificateur analogique.

De préférence, il est prévu après l'étape h) une étape i) de comparaison du signal obtenu à l'étape h) avec ledit seuil fonction de la tension maximale de saturation ou d'écrêtage, et application éventuelle d'un septième gain d'atténuation globale éventuelle sur l'ensemble des fréquences au cas où l'amplitude de ce signal dépasse ledit seuil fonction de la tension maximale de saturation ou d'écrêtage.

Le procédé peut par ailleurs comprendre, après les étapes e) et/ou h), une étape f) (respectivement j)) d'application au signal obtenu à l'étape e) (respectivement h) d'un traitement de compensation des non-linéarités, fonction des caractéristiques connues de non-linéarité de réponse du haut-parleur.

Dans un mode de réalisation avantageux, le procédé comporte après l'étape h) des étapes de : i) comparaison du signal obtenu à l'étape h) avec ledit seuil fonction de la tension maximale de saturation ou d'écrêtage, et application éventuelle d'un septième gain d'atténuation globale éventuelle sur l'ensemble des fréquences au cas où l'amplitude de ce signal dépasse ledit seuil fonction de la tension maximale de saturation ou d'écrêtage ; et j) application au signal obtenu à l'étape i) d'un traitement de compensation des non-linéarités, fonction des caractéristiques connues de non-linéarité de réponse du haut-parleur, ledit traitement de compensation des non-linéarités étant désactivé au cas où, à l'étape i), l'amplitude du signal en amont dépasse ledit seuil fonction de la tension maximale de saturation ou d'écrêtage.

Le procédé de l'invention peut être généralisé au cas où l'on connaît, outre l'excursion, des caractéristiques du haut-parleur en fonction du signal appliqué à ses bornes pour au moins un paramètre additionnel :
l'étape c) comprend en outre le calcul d'une valeur courante d'au moins l'un desdits paramètres pour le signal obtenu à l'étape b), en fonction desdites caractéristiques connues du paramètre additionnel tel que : vitesse de l'air dans un évent d'enceinte acoustique associée au haut-parleur ; température de bobine du haut-parleur ; courant de bobine du haut-parleur ; et/ou excursion d'une membrane passive associée au haut-parleur. Dans ce cas, l'étape d) comprend en outre la comparaison de la valeur courante de ce paramètre additionnel calculée à l'étape c) avec une valeur maximale correspondante respective, le troisième gain d'atténuation éventuelle étant calculé également au cas où la valeur courante du paramètre additionnel dépasse la valeur maximale correspondante respective.

On va maintenant décrire un exemple de mise en oeuvre du dispositif de l'invention, en référence aux dessins annexés.
La Figure 1 illustre, sous forme de schéma par blocs, les étapes de traitement du procédé de l'invention et leur enchaînement.
La Figure 2 est un exemple de réponse en fréquence d'un filtre de type *lowshelf* utilisé dans le traitement selon l'invention.
La Figure 3 montre la caractéristique de réponse en fréquence d'un haut-parleur de basses de type *subwoofer,* et l'amélioration qu'il est possible d'obtenir par le traitement de renforcement selon l'invention.

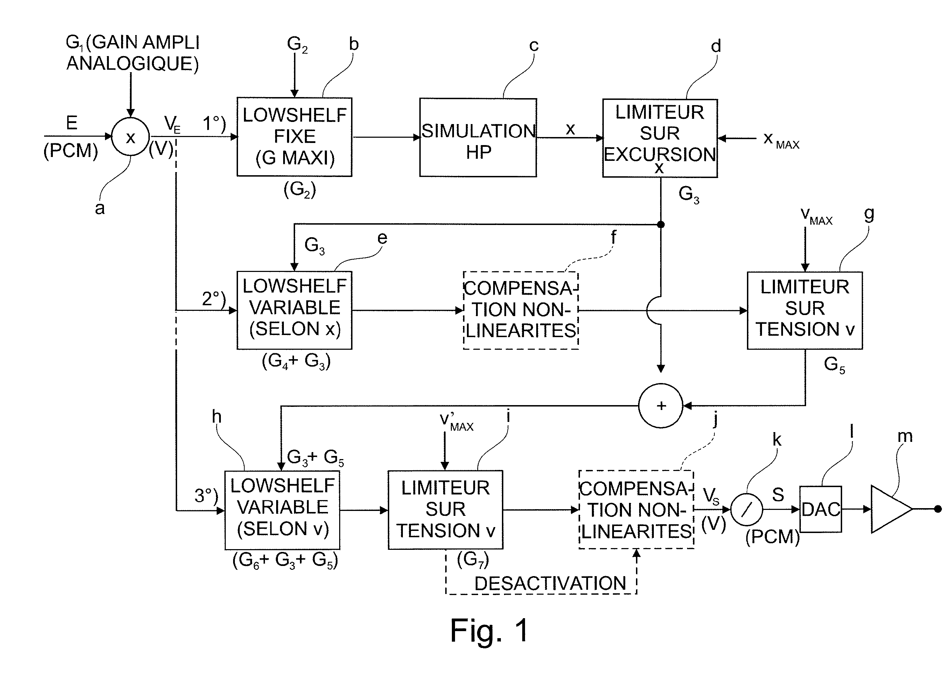

La Figure 1 illustre, sous forme de schéma par blocs, les étapes de traitement du procédé de l'invention et leur enchaînement.

On notera toutefois que, bien que ce schéma soit présenté sous forme de circuits interconnectés, la mise en oeuvre des différentes fonctions est essentiellement logicielle, et cette représentation n'a qu'un caractère illustratif. Le logiciel peut notamment être mis en oeuvre au sein d'une puce dédiée de traitement de signal numérique de type DSP.

Dans la mesure où l'algorithme de traitement de l'invention simule le comportement d'un haut-parleur et d'un amplificateur, il utilise des grandeurs physiques réelles (excursion en millimètres, tension en volts, etc.). De ce fait, comme le signal audio à reproduire *E* appliqué en entrée est un signal sans dimension (par exemple un signal de type PCM qui est le standard le plus courant en audio numérique), il est nécessaire, dans une première étape désignée a, de convertir en termes de tension (volts) ce signal sans dimension *E.* Cette conversion est effectuée en connaissant le gain G₁ de l'amplificateur analogique (étage m sur la figure) qui sera utilisé après le traitement numérique (étages a à k sur la figure), en aval du convertisseur numérique/analogique (étage l sur la figure). G₁ correspond à un facteur de conversion lié à la tension de crête obtenue en sortie pour un signal pleine échelle en entrée, avec un gain d'amplification de 0 dB.

Le signal de tension *V_{E}* ainsi obtenu est appliqué en entrée à trois chaînes de traitement correspondant respectivement aux étages référencés b-c-d, e-f-g et h-i-i, chacune de ces trois chaînes de traitement comprenant en entrée un filtre de type *lowshelf,* respectivement b, e et h.

Inversement, le signal final issu des étapes de traitement b à i fera l'objet, comme on le décrira plus en détail, d'une conversion inverse (étape k) pour obtenir un signal de sortie S sans dimension (signal PCM), appliqué à un convertisseur numérique/analogique (étape l) pilotant un amplificateur de puissance analogique (schématisé par l'étage m).

On notera que les traitements des trois chaînes b-c-d, e-f-g et h-j-1 sont exécutés en cascade, c'est-à-dire que le résultat de l'une des chaînes de traitement sert de paramètre d'entrée pour la chaîne suivante : ainsi, le résultat des traitements b-c-d sert de paramètre d'entrée pour le traitement de la chaîne e-f-g, et le résultat des traitements b-c-d et/ou e-f-g sert de paramètre d'entrée pour la chaîne de traitement h-i-i.

Concrètement, ces traitements sont effectués par des algorithmes de calcul exécutés de façon itérative à la fréquence d'échantillonnage, pour toutes les trames successives de signal (par exemple 1024 échantillons).

On va maintenant expliciter la manière dont le filtre *lowshelf,* tel que celui des étages b, e ou h, opère sur le signal qui lui est appliqué en entrée.

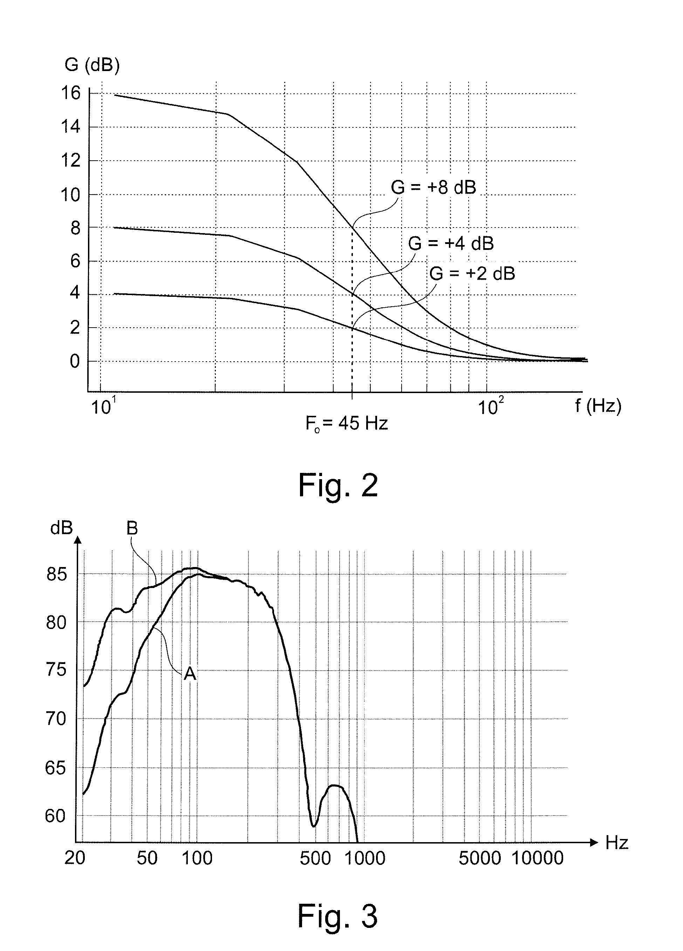

Un tel filtre *lowshelf* du second ordre présente une caractéristique telle que celle illustrée Figure 2.

Le filtrage appliqué est déterminé par trois paramètres : la fréquence pivot ou "fréquence de coupure" F₀, la consigne de gain G et le facteur de qualité Q. Dans l'exemple illustré, le filtre *lowshelf* possède une fréquence pivot F₀ de 45 Hz, ce qui signifie que le signal présentera une amplification à cette fréquence de G = +2 dB, G = +4 dB, G = +8 dB ... selon le réglage du gain G, avec une pente uniforme de part et d'autre de cette fréquence. Vers le haut, la bande passante de ce filtre *lowshelf* est limitée à une fréquence maximale de 100 Hz par exemple, un gain unité (0 dB) étant appliqué à toutes les fréquences supérieures. Vers le bas, dans les fréquences les plus graves, en-deçà d'une fréquence d'environ 20 Hz dans l'exemple illustré, le gain d'amplification est rendu constant, la caractéristique présentant une forme sensiblement en plateau (*shelf*).

Les filtres *lowshelf* utilisés dans le cadre de l'invention présenteront une fréquence F₀ et un facteur de qualité Q constants, et une consigne de gain variable, le gain maximal pour les fréquences les plus basses pouvant atteindre +16 dB à 10 Hz.

On va maintenant décrire en détail chacune des étapes de traitement correspondant aux étages b à m.

L'étape b correspond à un filtrage *lowshelf* de gain fixe G₂ appliqué au signal de tension V_{E}.

Ce gain G₂ est un gain fixe, correspondant à la valeur maximum du gain de consigne par lequel sera filtré le signal (par exemple G = +8 dB dans l'exemple illustré Figure 2). On verra par la suite que les limitations du système feront que l'on atténuera ce gain G pour les autres filtres ou qu'on le laissera à cette valeur maximale G₂.

Le signal issu du filtrage b correspond à la tension que l'on appliquerait aux bornes du haut-parleur de l'installation. Le comportement de ce haut-parleur est simulé à l'étape c de manière à délivrer une information x d'excursion mécanique de la membrane en fonction de la tension appliquée à la bobine.

La modélisation du fonctionnement d'un haut-parleur a été décrite par de nombreux auteurs, et ne sera pas décrite plus en détail. Cette modélisation décrit le comportement électromécanique et mécano-acoustique des différents éléments du haut-parleur, et permet de connaître l'excursion x de la membrane ainsi que, si besoin, l'intensité *i* traversant la bobine.

La connaissance de l'excursion x de la membrane permet, à l'étape d, de comparer cette valeur à un seuil déterminé *x_{MAX}* au-delà duquel on considère l'excursion comme trop importante (risque d'endommagement du haut-parleur, apparition de distorsions, ...). Si le seuil est dépassé, on détermine alors un gain d'atténuation de consigne G₃, inférieur à l'unité, qu'il faudrait appliquer afin de réduire le signal pour que l'excursion reste dans la plage autorisée.

Ce premier gain d'atténuation de consigne G₃ est utilisé comme paramètre d'entrée de la deuxième chaîne de traitement e-f-g.

Ainsi, à l'étape e le signal de tension *V_{E}* (c'est-à-dire le signal qui avait été appliqué en entrée du premier filtre *lowshelf* de l'étape b) est de nouveau filtré, cette fois-ci par un filtre *lowshelf* dont le gain est variable : ce gain est à un instant donné la somme d'une valeur de gain fixe G₄ (gain propre du *lowshelf* e) et de l'atténuation éventuelle G₃ calculée à l'étape d (atténuation destinée à éviter tout dépassement de l'excursion *x* de la membrane du haut-parleur). Le gain G₄ est typiquement égal à G₂, en tous cas il ne doit pas être supérieur à G₂.

Le traitement opéré à l'étape suivante f sur le signal délivré par le second filtre *lowshelf* e est une étape optionnelle de compensation des non-linéarités du haut-parleur. En effet, si l'on a modélisé le comportement du haut-parleur, on est capable de prédire les non-linéarités de ce comportement, et les compenser par un traitement approprié appliqué au signal. Un tel traitement est en soi connu, et pour cette raison on ne le décrira pas plus en détail.

La valeur du signal délivré par le filtre *lowshelf* e, éventuellement compensée des non-linéarités par le traitement de l'étape f, est comparée à une valeur *v_{MAX}* inférieure ou égale, de préférence strictement inférieure, à la tension maximale admissible sur l'amplificateur (étape g). Si la tension calculée par la chaîne de traitement e-f vient à dépasser ce seuil, alors un gain d'atténuation de consigne G₅ est calculé, correspondant à l'atténuation qu'il serait nécessaire d'appliquer au signal en entrée pour éviter toute saturation ou écrêtage audio sur l'amplificateur analogique lors de l'amplification du signal. Cette comparaison et le calcul du gain G₅ correspondant sont effectués de la même manière qu' à l'étape d pour l'excursion maximale *x_{MAX}* et le calcul du gain respectif G₃.

On notera que la compensation optionnelle des non-linéarités de l'étape f est opérée en amont de l'étage g, car le traitement de compensation des non-linéarités a généralement tendance à augmenter la tension du signal, et doit donc être pris en compte pour vérifier que le signal compensé des non-linéarités ne dépasse pas la limite admissible *v_{MAX}.*

Les deux chaînes de traitement b-c-d et e-f-g (ou e-g) ont ainsi permis de déterminer deux gains d'atténuation de consigne respectifs éventuels G₃ et G₅ pour éviter tout dépassement de l'excursion *x* et de la tension d'amplification, par rapport aux maxima admissibles respectifs.

Les gains G₃ et/ou G₅ ainsi éventuellement calculés sont utilisés comme paramètres d'entrée pour la troisième chaîne de traitement h-i-i.

Cette chaîne de traitement comprend un filtrage *lowshelf* variable h recevant en entrée le signal *V_{E},* c'est-à-dire le même signal que celui qui était appliqué aux étages de filtrage b et e précédemment exposés.

Le gain appliqué à l'étape h est un gain variable, comprenant à un instant donné un gain fixe G₆ (gain propre du *lowshelf* h), éventuellement corrigé d'une atténuation correspondant au gain de consigne G₃ ou G₅, ou doublement corrigé par les atténuations cumulées G₃+G₅. Typiquement, on aura G₆ = G₄ = G₂, en tout état de cause G₄ et G₆ ne devront pas être supérieurs à G₂.

Le signal résultant fait l'objet du traitement suivant (étape i) qui est opéré par un étage limiteur de tension de type classique, agissant sur toutes les composantes du signal (et pas seulement sur les composantes graves comme dans le cas d'un filtrage *lowshelf*) : si la tension appliquée en entrée dépasse la tension maximale admissible *v'_{MAX}* de l'amplificateur, alors un gain atténuateur G₇ est appliqué au signal ; dans le cas contraire, aucune limitation n'est appliquée et le signal est transmis tel quel aux étages aval.

La limitation opérée par l'étage i est nécessaire dans le cas où le dépassement de la tension au-delà du seuil *v'_{MAX}* ne serait pas dû au signal des basses fréquences renforcé par le filtre *lowshelf* h, mais par exemple par un gain d'amplification élevé demandé par l'utilisateur du système faisant dépasser le signal audio au-delà de la dynamique acceptée par l'amplificateur.

En aval des étages h et i peut être prévu, optionnellement, un étage i de compensation des non-linéarités, d'un type comparable à l'étage f précédemment décrit.

On notera cependant que, si le signal entrant dans cet étage j a été atténué par l'effet du limiteur de l'étage amont i, alors le calcul de la loi de contrôle de la compensation des non-linéarités est désactivé et l'étage i se contente de transmettre le signal sans le modifier. En effet, le processus de limitation pleine bande de l'étage i introduit, par nature, des distorsions et il n'est pas utile, voire néfaste, de tenter d'annuler les distorsions d'un système dans le cas d'un signal de ce type.

Il est à noter que l'étage i de compensation des non-linéarités est susceptible d'ajouter de la puissance au signal de tension final *V_{S}* obtenu en sortie. Aussi, il est nécessaire que l'étage limiteur i précédant cet étage i opère par rapport à un seuil *v'_{MAX}* prenant en compte une marge suffisante par rapport à la tension maximale *v_{MAX}* susceptible d'être délivrée par l'amplificateur audio, si l'option de compensation des non-linéarités de l'étage i est activée.

Le signal de tension *V_{S}* finalement obtenu (valeur en volts) fait ensuite l'objet d'une conversion inverse, à l'étage k, en un signal de sortie S sans dimension, par exemple de type signal numérique PCM, en divisant le signal *V_{S}* par le gain d'amplification.

Le signal ainsi obtenu peut être alors reproduit, après conversion numérique/analogique (étage l) et amplification finale de puissance (étage m).

Le résultat obtenu est par exemple celui illustré Figure 3, qui montre en A la courbe de réponse acoustique de l'ensemble haut-parleur/enceinte en l'absence de traitement de renforcement. La courbe B montre le résultat obtenu avec application du traitement selon l'invention, qui procure un gain dans les fréquences les plus basses pouvant atteindre +10 dB, et ceci sans aucun risque :
- ni d'endommagement de la membrane du fait d'une excursion excessive,
- ni d'écrêtage ou de saturation de l'amplificateur du fait de la puissance accrue restituée dans le registre grave,
- ni d'introduction d'aucune distorsion,
et ceci avec amélioration éventuelle du signal, si l'on choisit de mettre en oeuvre la compensation optionnelle des non-linéarités de réponse de l'ensemble électro-acoustique.

## Revendications

1. Un procédé de renforcement des fréquences graves dans un signal audio numérique destiné à être reproduit par un équipement comprenant un haut-parleur présentant des caractéristiques connues d'excursion en fonction du signal appliqué à ses bornes, et un amplificateur présentant des caractéristiques connues de tension maximale de saturation ou d'écrêtage,
**caractérisé en ce qu'**il comprend les étapes de traitement successives suivantes :
a) conversion du signal audio numérique (PCM), initialement sans dimension, en un autre signal numérique représentatif d'une tension électrique (*V_{E}*)*,* en fonction d'un premier gain prédéterminé (G₁) d'amplificateur analogique ;
b) application au signal obtenu à l'étape a) d'un premier filtrage de type *lowshelf,* apte à amplifier sélectivement, d'un deuxième gain prédéterminé (G₂), les fréquences inférieures à une fréquence pivot donnée (Fo) ;
c) calcul d'une valeur courante d'excursion (*x*) du haut-parleur pour le signal obtenu à l'étape b), en fonction desdites caractéristiques connues d'excursion ;
d) comparaison de la valeur courante d'excursion (*x*) calculée à l'étape c) avec une valeur maximale d'excursion (*x_{MAX}*), et calcul d'un troisième gain (G₃) d'atténuation éventuelle au cas où la valeur courante d'excursion dépasse la valeur maximale d'excursion ;
e) application au signal obtenu à l'étape a) d'un deuxième filtrage de type *lowshelf,* apte à amplifier sélectivement, d'un quatrième gain (G₄) prédéterminé, non supérieur audit deuxième gain prédéterminé (G₂) et le cas échéant réduit du troisième gain (G₃) d'atténuation éventuelle calculé en amont à l'étape d), les fréquences inférieures à la fréquence pivot ;
g) comparaison du signal obtenu à l'étape e) avec ladite tension maximale (*v_{MAX}*) de saturation ou d'écrêtage, et calcul d'un cinquième gain (G₅) d'atténuation éventuelle au cas où l'amplitude de ce signal dépasse un seuil fonction de la tension maximale de saturation ou d'écrêtage ;
h) application au signal obtenu à l'étape a) d'un troisième filtrage de type *lowshelf,* apte à amplifier sélectivement, d'un sixième gain (G₆) prédéterminé, non supérieur audit deuxième gain prédéterminé (G₂) et le cas échéant réduit des troisième (G₃) et cinquième (G₅) gains d'atténuation éventuelle calculés en amont aux étapes d) et g), les fréquences inférieures à la fréquence pivot ;
k) conversion inverse du signal (*V_{S}*) obtenu à l'étape h) en un signal audio numérique (*S*) sans dimension, en fonction dudit premier gain prédéterminé d'amplificateur analogique.

2. Le procédé de la revendication 1, comportant après l'étape h) une étape de :
i) comparaison du signal obtenu à l'étape h) avec ledit seuil fonction de la tension maximale de saturation ou d'écrêtage, et application éventuelle d'un septième gain (G₇) d'atténuation globale éventuelle sur l'ensemble des fréquences au cas où l'amplitude de ce signal dépasse ledit seuil fonction de la tension maximale (*v_{MAX}*) de saturation ou d'écrêtage.

3. Le procédé de la revendication 1, comportant après l'étape e) une étape de :
f) application au signal obtenu à l'étape e) d'un traitement de compensation des non-linéarités, fonction des caractéristiques connues de non-linéarité de réponse du haut-parleur.

4. Le procédé de la revendication 1, comportant après l'étape h) une étape de :
j) application au signal obtenu à l'étape h) d'un traitement de compensation des non-linéarités, fonction des caractéristiques connues de non-linéarité de réponse du haut-parleur.

5. Le procédé des revendications 2 et 4 prises en combinaison, comportant après l'étape h) des étapes de :
i) comparaison du signal obtenu à l'étape h) avec ledit seuil fonction de la tension maximale (*v_{MAX}*) de saturation ou d'écrêtage, et application éventuelle d'un septième gain (G₇) d'atténuation globale éventuelle sur l'ensemble des fréquences au cas où l'amplitude de ce signal dépasse ledit seuil fonction de la tension maximale de saturation ou d'écrêtage ; et
j) application au signal obtenu à l'étape i) d'un traitement de compensation des non-linéarités, fonction des caractéristiques connues de non-linéarité de réponse du haut-parleur, ledit traitement de compensation des non-linéarités étant désactivé au cas où, à l'étape i), l'amplitude du signal en amont dépasse ledit seuil fonction de la tension maximale (*v_{MAX}*) de saturation ou d'écrêtage.

6. Le procédé de la revendication 1, dans lequel, le haut-parleur présentant, outre l'excursion, des caractéristiques connues d'au moins un paramètre additionnel en fonction du signal appliqué aux bornes du haut-parleur :
- l'étape c) comprend en outre le calcul d'une valeur courante d'au moins l'un desdits paramètres pour le signal obtenu à l'étape b), en fonction desdites caractéristiques connues du paramètre additionnel ; et
- l'étape d) comprend en outre la comparaison de la valeur courante du paramètre additionnel calculée à l'étape c) avec une valeur maximale correspondante respective, le troisième gain (G₃) d'atténuation éventuelle étant calculé également au cas où la valeur courante du paramètre additionnel dépasse la valeur maximale correspondante respective.

7. le procédé de la revendication 6, dans lequel ledit paramètre additionnel est un paramètre du groupe formé par : vitesse de l'air dans un évent d'enceinte acoustique associée au haut-parleur ; température de bobine du haut-parleur ; courant de bobine du haut-parleur ; et/ou excursion d'une membrane passive associée au haut-parleur.

## Patentansprüche

1. Verfahren zur Verstärkung der tiefen Frequenzen in einem digitalen Audiosignal, das dazu bestimmt ist, durch eine Ausrüstung wiedergegeben zu werden, die einen Lautsprecher, der bekannte Hubeigenschaften in Abhängigkeit des an seine Anschlüsse angelegten Signals aufweist, und einen Verstärker aufweist, der bekannte maximale Sättigungs- oder Spitzenbegrenzungspannungseigenschaften aufweist,
**dadurch gekennzeichnet, dass** es die folgenden aufeinanderfolgenden Verarbeitungsschritte aufweist:
a) Umwandeln des anfangs dimensionslosen digitalen Audiosignals (PCM) in ein anderes digitales Signal, das für eine elektrische Spannung (*V_{E}*) charakteristisch ist, in Abhängigkeit von einer ersten vorbestimmten Analogverstärkerverstärkung (G₁);
b) Anwenden einer ersten Filterung des Typs Lowshelf auf das im Schritt a) erhaltene Signal, die geeignet ist, die Frequenzen, die niedriger sind als eine gegebene Schwenkfrequenz (Fₒ), selektiv um eine zweite vorbestimmte Verstärkung (G₂) zu verstärken;
c) Berechnen eines aktuellen Hubwertes (x) des Lautsprechers für das im Schritt b) erhaltene Signal in Abhängigkeit von den bekannten Hubeigenschaften;
d) Vergleichen des im Schritt c) berechneten aktuellen Hubwertes (x) mit einem maximalen Hubwert (*x_{MAX}*) und Berechnen einer dritten Verstärkung (G₃), gegebenenfalls mit einer Dämpfung, falls der aktuelle Hubwert den maximalen Hubwert überschreitet;
e) Anwenden einer zweiten Filterung des Typs Lowshelf auf das im Schritt a) erhaltene Signal, die geeignet ist, die Frequenzen, die niedriger sind als die Schwenkfrequenz, selektiv mit einer vorbestimmten vierten Verstärkung (G₄), die nicht höher als die zweite vorbestimmte Verstärkung (G₂) und gegebenenfalls um die dritte Verstärkung (G₃), gegebenenfalls mit einer Dämpfung, verringert ist, zu verstärken, die vorgelagert im Schritt d) berechnet wurde;
g) Vergleichen des im Schritt e) erhaltenen Signals mit der maximalen Sättigungs- oder Spitzenbegrenzungsspannung (*V_{MAX}*) und Berechnen einer fünften Verstärkung (G₅), gegebenenfalls mit einer Dämpfung, falls die Amplitude dieses Signals eine Schwelle überschreitet, die von der maximalen Sättigungs- oder Spitzenbegrenzungsspannung abhängig ist;
h) Anwenden einer dritten Filterung des Typs Lowshelf auf das im Schritt a) erhaltene Signal, die geeignet ist, die Frequenzen, die niedriger sind als die Schwenkfrequenz, selektiv um eine vorbestimmte sechste Verstärkung (G₆), die nicht höher als die zweite vorbestimmte Verstärkung (G₂) und gegebenenfalls um die dritte (G₃) und fünfte (G₅) Verstärkung, gegebenenfalls mit einer Dämpfung, verringert ist, zu verstärken, die vorgelagert in den Schritten d) und g) berechnet wurden;
k) inverses Umwandeln des im Schritt h) erhaltenen Signals *(V_{S})* in ein dimensionsloses digitales Audiosignal (*S*) in Abhängigkeit von der ersten vorbestimmten Verstärkung des Analogverstärkers.

2. Verfahren nach Anspruch 1, das nach dem Schritt h) einen Schritt für Folgendes aufweist:
i) Vergleichen des im Schritt h) erhaltenen Signals mit der Schwelle, die abhängig von der maximalen Sättigungs- oder Spitzenbegrenzungsspannung ist, und gegebenenfalls Anwenden einer siebten Verstärkung (G₇), gegebenenfalls mit einer globalen Dämpfung, auf sämtliche Frequenzen, falls die Amplitude dieses Signals die Schwelle überschreitet, die abhängig von der maximalen Sättigungs- oder Spitzenbegrenzungsspannung *(V_{MAX}*) ist.

3. Verfahren nach Anspruch 1, das nach dem Schritt e) einen Schritt für Folgendes aufweist:
f) Anwenden einer Verarbeitung zur Kompensierung der Nichtlinearitäten auf das im Schritt e) erhaltene Signal in Abhängigkeit von den bekannten Nichtlinearitätseigenschaften des Verhaltens des Lautsprechers.

4. Verfahren nach Anspruch 1, das nach dem Schritt h) einen Schritt für Folgendes aufweist:
j) Anwenden einer Verarbeitung zur Kompensierung der Nichtlinearitäten in Abhängigkeit von den bekannten Nichtlinearitätseigenschaften des Verhaltens des Lautsprechers auf das im Schritt h) erhaltene Signal.

5. Verfahren nach den Ansprüchen 2 und 4 in Verbindung miteinander, das nach dem Schritt h) die folgenden Schritte aufweist:
i) Vergleichen des im Schritt h) erhaltenen Signals mit der Schwelle, die von der maximalen Sättigungs- oder Spitzenbegrenzungsspannung (*V_{MAX}*) abhängig ist, und gegebenenfalls Anwenden einer siebten Verstärkung (G₇), gegebenenfalls mit einer globalen Dämpfung, auf sämtliche Frequenzen, falls die Amplitude dieses Signals die Schwelle überschreitet, die von der maximalen Sättigungs- oder Spitzenbegrenzungsspannung abhängig ist; und
j) Anwenden einer Verarbeitung zum Kompensieren der Nichtlinearitäten auf das im Schritt i) erhaltene Signal in Abhängigkeit von den bekannten Nichtlinearitätseigenschaften des Verhaltens des Lautsprechers, wobei die Verarbeitung zum Kompensieren der Nichtlinearitäten deaktiviert wird, falls im Schritt i) die Amplitude des vorgelagerten Signals die Schwelle überschreitet, die von der maximalen Sättigungs- oder Spitzenbegrenzungsspannung (*V_{MAX}*) abhängig ist.

6. Verfahren nach Anspruch 1, wobei, da der Lautsprecher neben dem Hub bekannte Eigenschaften von mindestens einem zusätzlichen Parameter aufweist, der von dem an die Anschlüsse des Lautsprechers angelegten Signal abhängig ist:
- der Schritt c) ferner die Berechnung eines aktuellen Werts von mindestens einem der Parameter für das im Schritt b) erhaltene Signal in Abhängigkeit von den bekannten Eigenschaften des zusätzlichen Parameters aufweist; und
- der Schritt d) ferner den Vergleich des aktuellen Werts des zusätzlichen Parameters, der im Schritt c) berechnet wurde, mit einem entsprechenden jeweiligen maximalen Wert aufweist, wobei die dritte Verstärkung (G₃) gegebenenfalls mit einer Dämpfung, auch in dem Fall berechnet wird, in dem der aktuelle Wert des zusätzlichen Parameters den jeweiligen entsprechenden Höchstwert überschreitet.

7. Verfahren nach Anspruch 6, wobei der zusätzliche Parameter ein Parameter von der Gruppe ist, die aus Folgendem gebildet ist: Luftgeschwindigkeit in einem Luftloch der dem Lautsprecher zugehörigen Lautsprecherbox; Spulentemperatur des Lautsprechers; Spulenstrom des Lautsprechers; und/oder Hub einer dem Lautsprecher zugehörigen Passivmembran.

## Claims

1. A method for reinforcing the bass frequencies in a digital audio signal intended to be rendered by an equipment comprising a loudspeaker having known characteristics of excursion as a function of the signal applied to its terminals, and an amplifier having known characteristics of maximum voltage of saturation or clipping, **characterized in that** it comprises the following successive steps of processing:
a) converting the digital audio signal (PCM), initially with no dimension, into another digital signal representative of an electric voltage (*V_{E}*), as a function of a first predetermined gain (G₁) of analogue amplifier;
b) applying to the signal obtained at step a) a first filtering of the *lowshelf* type, adapted to selectively amplify, by a second predetermined gain (G₂), the frequencies lower than a given pivot frequency (F₀);
c) calculating a current value of excursion (x) of the loudspeaker for the signal obtained at step b), as a function of said known characteristics of excursion;
d) comparing the current value of excursion (x) calculated at step c) with a maximum value of excursion (*x_{MAX}*) and calculating a third gain (G₃) of possible attenuation in the case where the current value of excursion exceeds the maximum value of excursion;
e) applying to the signal obtained at step a) a second filtering of the *lowshelf* type, adapted to selectively amplify, by a fourth predetermined gain (G₄), not higher than said second predetermined gain (G₂) and, as the case may be, reduced by the third gain (G₃) of possible attenuation previously calculated at step d), the frequencies lower than the pivot frequency;
g) comparing the signal obtained at step e) with said maximum voltage (*v_{MAX}*) of saturation or clipping, and calculating a fifth gain (G₅) of possible attenuation in the case where the amplitude of this signal exceeds a threshold function of the maximum voltage of saturation or clipping;
h) applying to the signal obtained at step a) a third filtering of the *lowshelf* type, adapted to selectively amplify, by a sixth predetermined gain (G₆), not higher than said second predetermined gain (G₂) and, as the case may be, reduced by the third (G₃) and fifth (G₅) gains of possible attenuation previously calculated at steps d) and g), the frequencies lower than the pivot frequency;
k) reversely converting the signal (*V_{S}*) obtained at step h) into a digital audio signal (S), with no dimension, as a function of said first predetermined gain of analogue amplifier.

2. The method of claim 1, including, after step h), a step of:
i) comparing the signal obtained at step h) with said threshold function of the maximum voltage of saturation or clipping, and possibly applying a seventh gain (G₇) of possible global attenuation to all the frequencies in the case where the amplitude of this signal exceeds said threshold function of the maximum voltage (*v_{MAX}*) of saturation or clipping.

3. The method of claim 1, including, after step e), a step of:
f) applying to the signal obtained at step e) a processing of non-linearity compensation, function of the known characteristics of non-linearity of the loudspeaker response.

4. The method of claim 1, including, after step h), a step of:
j) applying to the signal obtained at step h) a processing of non-linearity compensation, function of the known characteristics of non-linearity of the loudspeaker response.

5. The method of claims 2 and 4 taken in combination, including, after step h), steps of:
i) comparing the signal obtained at step h) with said threshold function of the maximum voltage (*v_{MAX}*) of saturation or clipping, and possibly applying a seventh gain (G₇) of possible global attenuation to all the frequencies in the case where the amplitude of this signal exceeds said threshold function of the maximum voltage of saturation or clipping; and
j) applying to the signal obtained at step i) a processing of non-linearity compensation, function of the known characteristics of non-linearity of the loudspeaker response, said processing of non-linearity compensation being deactivated in the case where, at step i), the amplitude of the upstream signal exceeds said threshold function of the maximum voltage (*v_{MAX}*) of saturation or clipping.

6. The method of claim 1, wherein, the loudspeaker having, besides the excursion, known characteristics of at least one additional parameter as a function of the signal applied to the terminals of the loudspeaker:
- step c) further comprises the calculation of a current value of at least one of said parameters for the signal obtained at step b), as a function of said known characteristics of the additional parameter; and
- step d) further comprises the comparison of the current value of the additional parameter calculated at step c) with a respective corresponding maximum value, the third gain (G₃) of possible attenuation being also calculated in the case where the current value of the additional parameter exceeds the respective corresponding maximum value.

7. The method of claim 6, wherein said additional parameter is a parameter of the group formed by: speed of air in an acoustic enclosure port associated with the loudspeaker; loudspeaker coil temperature; loudspeaker coil current; and/or excursion of a passive diaphragm associated with the loudspeaker.
